# EUROPEAN PATENT SPECIFICATION

(11) **EP 3 665 532 B1**
(45) Date of publication and mention of the grant of the patent: **30.12.2020**
(21) Application number: 18760152.1
(22) Date of filing: 09.08.2018
(51) Int. Cl.: G03F 7/038, G03F 7/075, G03F 7/32, G03F 7/40

(54) **CALCITE CHANNEL NANOFLUIDICS**
CALCITKANAL-NANOFLUIDIK
CANAL EN CALCITE POUR NANOFLUIDIQUE

(30) Priority: 09.08.2017 US 201715673147
(43) Date of publication of application: 17.06.2020
(73) Proprietor: Saudi Arabian Oil Company, Dhahran 31311 (SA)
(72) Inventor: CHA, Dong Kyu, Abqaiq 31311 (SA); AL OTAIBI, Mohammed, Abqaiq 31311 (SA); AL-YOUSEF, Ali Abdallah, Dhahran 31311 (SA)
(74) Representative: Fish & Richardson P.C.
(86) International application number: PCT/US2018/046118
(87) International publication number: WO 2019/032903

(56) References cited:
- WO-A2-2017/009710
- US-A1- 2013 236 698
- BECKER HOLGER ET AL: "Polymer microfluidic devices", TALANTA, ELSEVIER, AMSTERDAM, NL, vol. 56, no. 2, 11 February 2002 (2002-02-11), pages 267-287, XP002473389, ISSN: 0039-9140, DOI: 10.1016/S0039-9140(01)00594-X
- LEE SEUNG, LEE HYUNDO, GUPTA ANKUR, CHANG SEHOON, DOYLE PATRICK: "Site-Selective In Situ Grown Calcium Carbonate Micromodels with Tunable Geometry, Porosity, and Wettability", ADVANCED FUNCTIONAL MATERIALS, vol. 26, 1 July 2016 (2016-07-01), pages 4896-4905, XP009508747, ISSN: 1057-9257, DOI: 10.1002/adfm.201600573
- HAIXIA ZHENG ET AL: "Surface Effect on Oil Transportation in Nanochannel: a Molecular Dynamics Study", NANOSCALE RESEARCH LETTERS, SPRINGER, US, vol. 12, no. 1, 15 June 2017 (2017-06-15), pages 1-9, XP021246228, ISSN: 1931-7573, DOI: 10.1186/S11671-017-2161-2

## Description

### TECHNICAL FIELD

This patent relates to nanofluidics and more specifically for petrophysical application.

### BACKGROUND

Enhanced oil recovery methods are utilized to increase the amount of crude oil that can be extracted from an oil field. At small scales (channel sizes on the order or nanometers or micrometers), fluids can behave differently in that factors such as surface tension begin to dominate the system. With better understanding of fluid behavior at small scales, enhanced oil recovery methods can be improved to extract even more oil from a source rock or reservoir. Microfluidic models which can replicate conditions found in underground reservoirs have been developed to observe, evaluate, and understand physical and chemical phenomena in oil extraction and recovery.

WO 2017/009710 describes a device with nanochannels suitable for confinement and alignment of DNA molecules, as well as methods of fabricating and using the device. The device can include a sample microchannel and a collapsible material, one or more nanostructures on the roof or bottom surface of the sample microchannel, and a control microchannel. The microchannels can be formed within nanoslits in a substrate. The nanoslits can be formed using lithography.

US2013/0236698 describes a nanodevice with a plurality of nanoscale critical dimensions arranged as a stepped gradient across an elongated channel. The nanodevice can be fabricated by exposing a photoresist layer on a substrate to gray-scale radiation.

### SUMMARY

The present patent describes a method of fabricating calcite channels for nanofluidics. Certain aspects of the subject matter described here can be implemented as a method. Calcite channels are fabricated in a nanofluidic device. A photoresist is coated on a substrate, and a portion of the photoresist is exposed to a beam of electrons in a channel pattern. The exposed portion of the photoresist is developed to form a channel pattern, and calcite is deposited in the channel pattern using a calcite precursor gas. The deposited calcite includes at least one side having a length in a range of approximately 50 to 100 nanometers (nm). The photoresist remaining after developing the exposed portion of the photoresist is removed.

This, and other aspects, can include one or more of the following features. The substrate can be silicon. The photoresist can be a negative photoresist, such as polydimethylsiloxane (PDMS) or SU-8. Developing the photoresist can include dissolving the photoresist using a solvent and revealing a portion of the substrate. The solvent used to dissolve the photoresist can be propylene glycol methyl ether acetate (PGMEA), ethyl lactate, or di-acetone alcohol. Fabricating calcite channels in the nanofluidic device can include packaging the device in a casing. The casing can include a top portion which includes a window, a bottom portion to hold the device, an inlet connection to allow a fluid to enter the device, and an outlet connection to allow the fluid to exit the device. The window can be an electrically conductive and optically transparent material, such as silicon nitride (SiN).

Certain aspects of the subject matter described here can be implemented as a system. The system includes a nanofluidic device, a casing for the device, and an electron source for providing a beam of electrons. The device includes a bottom portion which includes a substrate, and a top portion which includes a calcite channel structure. The calcite channel structure includes at least one side having a length in a range of approximately 50 to 100 nm. This, and other aspects, can include one or more of the following features. The substrate can be silicon. The electron source can be a scanning electron microscope (SEM). The casing can include a top portion which includes a window, a bottom portion to hold the device, an inlet connection to allow a fluid to enter the device, and an outlet connection to allow the fluid to exit the device. The window can be an electrically conductive and optically transparent material, such as SiN.

The details of one or more implementations of the subject matter of this specification are set forth in the accompanying drawings and the description. Other features, aspects, and advantages of the subject matter will become apparent from the description, the drawings, and the claims.

### DESCRIPTION OF DRAWINGS

FIG. **1** is a schematic diagram illustrating an example method for fabricating a nanofluidic device, according to an implementation.
FIG. **2A** is a cross-sectional view of a schematic diagram illustrating an example nanofluidic device, according to an implementation.
FIG. **2B** is a top view of a schematic diagram illustrating an example nanofluidic device, according to an implementation.
FIG. **3** is a schematic diagram illustrating an example nanofluidic device system, according to an implementation.
FIG. **4** is a flowchart of an example method for fabricating a nanofluidic device, according to an implementation.

Like reference numbers and designations in the various drawings indicate like elements.

### DETAILED DESCRIPTION

The following detailed description describes a method of fabricating calcite channels for nanofluidics, and is presented to enable any person skilled in the art to make and use the disclosed subject matter in the context of one or more particular implementations. Various modifications, alterations, and permutations of the disclosed implementations can be made and will be readily apparent to those or ordinary skill in the art, and the general principles defined may be applied to other implementations and applications, without departing from scope of the disclosure. In some instances, details unnecessary to obtain an understanding of the described subject matter may be omitted so as to not obscure one or more described implementations with unnecessary detail and inasmuch as such details are within the skill of one of ordinary skill in the art. The present disclosure is not intended to be limited to the described or illustrated implementations, but to be accorded the widest scope consistent with the described principles and features.

A portion of the world's oil reserves exists in carbonate rocks, such as limestone and dolostone. These rocks, however, can vary considerably in characteristics such as texture, porosity, and permeability even across areas within the same formation. This variation makes consistent flow of oil difficult to achieve. Microfluidics is considered a useful method to characterize crude oil interactions with different fluids and with rock formations in petrophysics applications. Conventional calcite (CaCO₃) channel models comprise etched natural calcite crystal, but these models are on the scale of micrometers. Fluidics at a nano-scale (that is, on the order of nanometers), are beneficial to understand the physical and chemical phenomena of fluid-fluid and fluid-calcite rock interactions at an atomic scale.

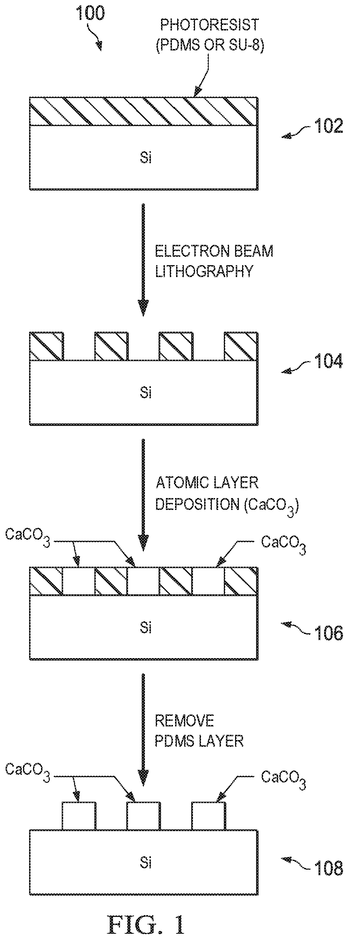

Referring to FIG. **1**, a method **100** for fabricating calcite channels in a nanofluidic device, starts at **102** by coating a photoresist on a substrate. In certain implementations, the photoresist is a negative photoresist, such as polydimethylsiloxane (PDMS) or SU-8. The substrate can have a clean and flat surface and can be made of, for example, silicon. The coating of the photoresist can be performed by spin coating to apply a layer of photoresist on the substrate at a spin rate in a range of approximately 500 to 2000 revolutions per minute (rpm). The spin rate can determine the thickness of the layer of photoresist. The thickness of the layer of photoresist can determine a height of resulting calcite channels in the nanofluidic device. Therefore, the thickness of the photoresist coating can be chosen based on the desired height for the calcite channels in the nanofluidic device, for example, a height less than 10 centimeters (cm). The preparation of photoresist can include edge bead removal (EBR) to remove any buildup of photoresist on the edge of the substrate. The preparation of photoresist can include a baking step which involves baking at approximately 200 degrees Fahrenheit (°F) for a duration of time, dependent on the thickness of the layer of photoresist. The baking temperature can also affect the duration of the baking step.

From **102**, method **100** proceeds to **104**, where a portion of the photoresist is exposed to a beam of electrons. Exposing a portion of the photoresist to a beam of electrons can cause the portion of the photoresist to be removed. In certain implementations, electron beam lithography, is used to remove the photoresist. Electron beam lithography is a technique for patterning at nanometer (nm) scale and includes scanning a beam of electrons on a resist, for example, PDMS. The lithographic process includes exposure of the resist and development of the exposed resist to form a pattern in the remaining resist. Exposure of the resist to an energy source, such as a beam of electrons, modifies the resist physically, chemically, or both. In certain implementations, the beam of electrons is supplied by a scanning electron microscope (SEM). The exposure of the resist can be followed by a post-exposure baking step which involves baking at approximately 200°F for a duration of time, dependent on the thickness of the layer of photoresist.

The portion of the photoresist that is exposed to the beam of electrons can be exposed in a channel pattern. In general, a portion of the photoresist is exposed to an energy source and developed to form the channel pattern. Sizes of the channel pattern can be chosen based on the desired size for the calcite channels in the nanofluidic device. For positive resists, the development of the resist removes the exposed portion of the resist. For negative resists, the development of the resist removes the unexposed portion of the resist. Developing the resist involves dissolving the resist using a solvent and revealing a portion of a surface of the substrate under the photoresist. In certain implementations, the solvent is an organic solvent, such as propylene glycol methyl ether acetate (PGMEA), ethyl lactate, or di-acetone alcohol. The development time depends on the thickness of the layer of photoresist. The portion of photoresist that remains after development forms an inverse pattern of the calcite channels in the finalized nanofluidic device. After development, the device can be rinsed with fresh solvent, followed by a second wash with another solvent, such as isopropyl alcohol. The device can then be dried with a gas, such as nitrogen.

From **104**, method **100** proceeds to **106**, where calcite is deposited in the channel pattern using a calcite precursor gas. In certain implementations, atomic layer deposition is used to deposit calcite. Atomic layer deposition is a technique for depositing a material from a vapor phase and includes a sequence of alternating introductions of gaseous chemical precursors that react with the substrate. The individual gas-surface reactions are called half-reactions. During each half-reaction, a precursor gas is introduced for a designated amount of time, to allow the precursor gas to fully react with the substrate surface and deposit a single layer at the surface. The device is then purged with an inert gas, such as nitrogen or argon, to remove unreacted precursor, reaction by-products, or both. The next precursor gas is then introduced to deposit another layer and similarly purged. The process cycles as alternating precursor gas is deposited layer by layer until the desired height is reached. In certain implementations, the atomic layer deposition process can continue until the calcite layers reach a similar or same height as the original coating of photoresist. The deposited calcite can have at least one side with a length in a range of approximately 50 to 100 nm. From **106**, method **100** proceeds to **108**, where the photoresist remaining after developing the exposed portion of the photoresist in **104** is removed. Removal of the remaining photoresist involves dissolving the photoresist using a solvent, such as the solvent used in developing the resist in **104**. The remaining calcite and substrate form the nanofluidic device.

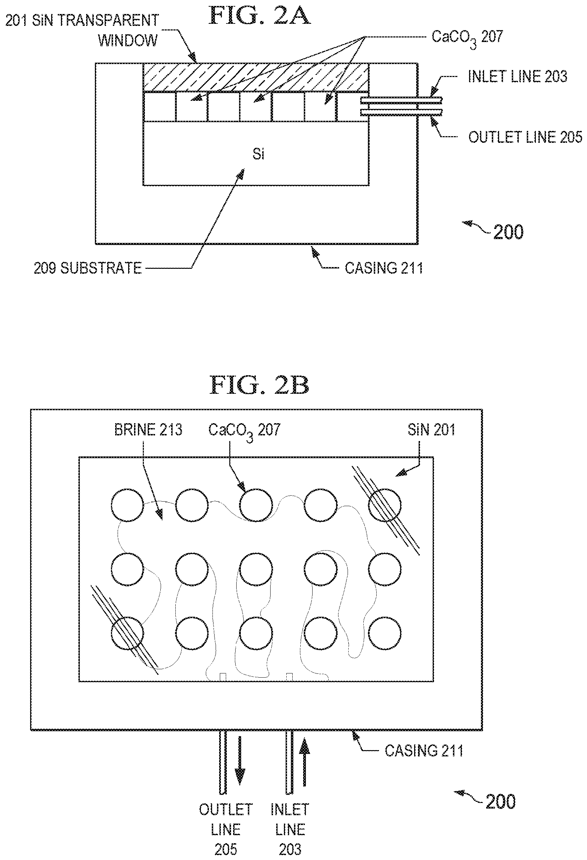

FIGs. **2A** and **2B** illustrate a cross-sectional view and a top view, respectively, of an example nanofluidic device **200**. The device **200** includes a silicon substrate **209** and calcite channels **207**. The calcite deposits that make up the channels **207** can have any shape, such as acylinder or a cuboid. In addition to varying calcite deposit shapes, the pattern of the calcite channels **207** can be varied. For example, the channels **207** can have a stacked row pattern, where the center of each calcite deposit is in line with a center of a calcite deposit in a row directly above or a row directly below, as illustrated in FIG. **2B**. In some implementations, the channels **207** can have a shifted row pattern, where the center of each calcite deposit is not in line with a center of any calcite deposit in a row directly above or a row directly below. The straight or curved edges of the calcite deposits and the channel pattern can represent a variety of geometries that occur in natural calcite reservoirs. In some implementations, the calcite channels **207** of the nanofluidic device **200** can have a length in a range of 50 to 100 nm in at least one dimension. For example, the width of each calcite channel **207** can be in the range of 50 to 100 nm.

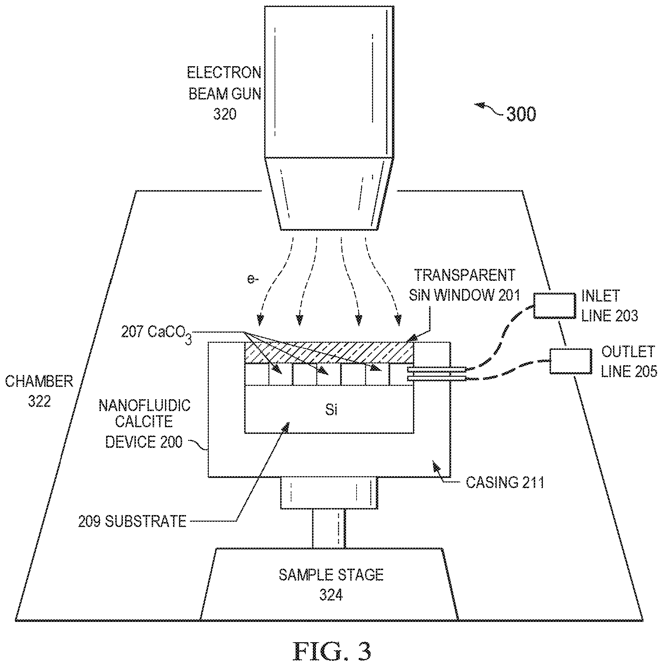

Still referring to FIGs. **2A** and **2B**, the silicon substrate **209** and the calcite channels **207** can be packaged in a casing **211** with a window **201** transparent to an electron beam on top of the calcite channels **207**. In certain implementations, the casing **211** can be made of a conductive metal, and the window **201** can be made of an electrically conductive material that is also optically transparent, such as silicon nitride (SiN). Electrical conductivity allows the window **201** to avoid accumulating an electric charge, and the transparency of the window **201** allows observation. As illustrated, the casing has an inlet connection **203** that allows a fluid, such as brine solution **213**, to enter the nanofluidic device **200** and an outlet connection **205** that allows fluid to exit. As shown in FIGs. **2A**, **2B**, and **3**, the inlet connection **203** and outlet connection **205** can be located on the same side of device the **200**. In some implementations, the inlet connection **203** and outlet connection **205** can be located on opposite or adjacent sides of the device **200**.

FIG. **3** illustrates an example system **300** for testing a nanofluidic device **200**. For example, the system **300** can image a reaction between the calcite channels **207** and a fluid. The nanofluidic device **200** is positioned on a sample stage **324** located inside a chamber **322**. The chamber **322** can isolate the device **200** from outside interference and can be evacuated-that is, a vacuum can be produced within the chamber. Fluid, such as brine solution, can be introduced to the device by inlet line **203**, and the fluid can exit by outlet line **205**. As fluid flows into and out of the device **200**, an electron beam gun **320** emits an electron beam to produce an image of the calcite channels **207** while interacting with the fluid. The electron beam gun **320**, chamber **322**, and sample stage **324** can be components of a single apparatus, such as an SEM. In certain implementations, the electron beam gun **320** is the same source of electrons used to perform electron beam lithography in fabricating the nanofluidic device **200**, for example, a modified SEM capable of performing electron beam lithography.

Calcite reservoirs are typically heterogeneous. Some areas of the reservoir can contain large voids, whereas other areas can have poor connectivity and low permeability. Acid injection is an enhanced oil recovery method that can increase the connectivity of an area of a reservoir. Acid injection can include a brine solution **213** with acid content, for example 10% hydrochloric acid. Acid injection causes carbonate dissolution, and the dynamics of formation dissolution due to acid flow on a pore-scale and an atomic-scale can determine the net flow behavior. The dynamics can also determine other reservoir characteristics such as likelihood for leakage, oil and gas recovery, and storage capacity. As brine solution **213** flows through the nanofluidic device **200**, the SEM can be utilized to observe calcite dissolution and preferential flow of brine at a nanometer scale in the device **200**. The observations can then be used to quantify acid dissolution of carbonates and to predict the migration of brine through aquifers, such as calcite formations.

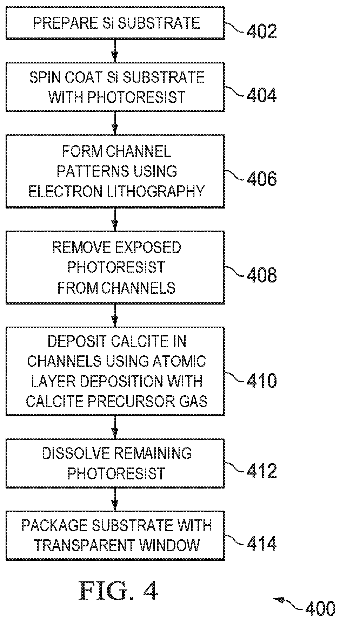

FIG. **4** is a flowchart illustrating an example method **400** for fabricating a calcite channel nanofluidic device. At **402**, a silicon substrate is prepared to be the bottom of the nanofluidic device. The size and shape of the substrate can be determined by a sample stage **324** of an SEM. In certain implementations, the nanofluidic device is packaged, and the size of the substrate is smaller than the sample stage **324**. Substrate preparation can include cleaning of the substrate. At **404**, photoresist is coated on the substrate, for example, by spin coating. A number of parameters can determine the thickness of the coated layer of photoresist such as a spin rate, photoresist viscosity, temperature, and other parameters. In some implementations, the thickness can equal a desired height of calcite channels in a nanofluidic device. In certain implementations, the photoresist is a negative photoresist, such as PDMS or SU-8. At **406**, channel patterns are formed using electron beam lithography. Forming channel patterns involves exposing a portion of the photoresist to a beam of electrons, for example, from an SEM. At **408**, the exposed portion of the photoresist is developed, that is, removed. Developing the photoresist involves dissolving the photoresist using a solvent, such as PGMEA, ethyl lactate, or di-acetone alcohol. Developing the photoresists also involves revealing a portion of surface of the substrate. At **410**, calcite is deposited in the channel patterns using atomic layer deposition with calcite precursor gas. Atomic layer deposition involves depositing calcite, layer by layer. In certain implementations, calcite is deposited layer by layer until the calcite channel height is similar to or the same as the original height of the coated photoresist at **404**. At **412**, the remaining portion of photoresist is dissolved using a solvent. The calcite channel structure deposited on the substrate and the substrate remain. The formed calcite channels can have a length in a range of 50 to 100nm in at least one dimension. At **414**, the device, which includes the substrate and calcite channels, is packaged in a casing. The casing can include a top portion with a window, a bottom portion that can hold the device, an inlet connection to allow a fluid to enter the device, and an outlet connection to allow the fluid to exit the device. The window can be made of an electrically conductive and optically transparent material, such as SiN, and can be set on top of the calcite channels deposited on the substrate. In certain implementations, the package includes a metal casing around the substrate.

While this specification contains many specific implementation details, these should not be construed as limitations on the scope of any invention or on the scope of what may be claimed, but rather as descriptions of features that may be specific to particular implementations of particular inventions. Certain features that are described in this specification in the context of separate implementations can also be implemented, in combination, in a single implementation. Conversely, various features that are described in the context of a single implementation can also be implemented in multiple implementations, separately, or in any suitable sub-combination. Moreover, although previously described features may be described as acting in certain combinations and even initially claimed as such, one or more features from a claimed combination can, in some cases, be excised from the combination, and the claimed combination may be directed to a sub-combination or variation of a sub-combination.

Particular implementations of the subject matter have been described. Other implementations, alterations, and permutations of the described implementations are within the scope of the following claims as will be apparent to those skilled in the art. While operations are depicted in the drawings or claims in a particular order, this should not be understood as requiring that such operations be performed in the particular order shown or in sequential order, or that all illustrated operations be performed (some operations may be considered optional), to achieve desirable results.

Moreover, the separation or integration of various system modules and components in the previously described implementations should not be understood as requiring such separation or integration in all implementations, and it should be understood that the described program components and systems can generally be integrated together in a single software product or packaged into multiple software products.

Accordingly, the previously described example implementations do not define or constrain this disclosure. Other modifications are also possible without departing from the scope of the appended claims.

## Claims

1. A method of fabricating calcite channels in a nanofluidic device (200), the method comprising:
coating a photoresist on a substrate (209);
exposing a portion of the photoresist to a beam of electrons, wherein the portion is exposed in a channel pattern;
developing the exposed portion of the photoresist to form the channel pattern;
depositing calcite in the channel pattern using a calcite precursor gas, wherein the deposited calcite includes at least one side having a length in a range of approximately 50 to 100 nanometers; and
removing the photoresist remaining after developing the exposed portion of the photoresist.

2. The method of claim 1, wherein the substrate comprises silicon.

3. The method of claim 1, wherein the photoresist comprises a negative photoresist.

4. The method of claim 3, wherein the negative photoresist comprises polydimethylsiloxane or SU-8.

5. The method of claim 1, wherein developing the photoresist comprises dissolving the photoresist using a solvent and revealing a portion of the substrate.

6. The method of claim 5, wherein the solvent comprises propylene glycol methyl ether acetate, ethyl lactate, or di-acetone alcohol.

7. The method of claim 1, further comprising packaging the device in a casing (211), wherein the casing comprises:
a top portion comprising a window (201);
a bottom portion configured to hold the device;
an inlet connection (203) configured to allow a fluid to enter the device; and
an outlet connection (205) configured to allow the fluid to exit the device.

8. The method of claim 7, wherein the window comprises an electrically conductive and optically transparent material.

9. The method of claim 8, wherein the conductive and transparent material comprises silicon nitride.

10. A system comprising:
a nanofluidic device (200), wherein the device comprises a bottom portion comprising a substrate (209) and a top portion comprising a calcite channel structure (207), the calcite channel structure comprising at least one side having a length in a range of approximately 50 to 100 nanometers;
a casing (211) for the device; and
an electron source for providing a beam of electrons.

11. The system of claim 10, wherein the substrate comprises silicon.

12. The system of claim 10, wherein the electron source is a scanning electron microscope.

13. The system of claim 10, wherein the casing comprises:
a top portion comprising a window (201);
a bottom portion configured to hold the device;
an inlet connection (203) configured to allow a fluid to enter the device; and
an outlet connection (205) configured to allow the fluid to exit the device.

14. The system of claim 13, wherein the window comprises an electrically conductive and optically transparent material.

15. The system of claim 14, where in the conductive and transparent material comprises silicon nitride.

## Patentansprüche

1. Verfahren zum Erzeugen von Calcitkanälen in einer Nanofluidikvorrichtung (200), wobei man bei dem Verfahren:
ein Substrat (209) mit einem Photoresist überzieht;
einen Teil des Photoresists mit einem Elektronenstrahl belichtet, wobei der Teil in einem Kanalmuster belichtet wird;
den belichteten Teil des Photoresists zur Bildung des Kanalmusters entwickelt;
unter Verwendung eines Calcitvorläufergases Calcit in dem Kanalmuster abscheidet, wobei der abgeschiedenene Calcit mindestens eine Seite mit einer Länge im Bereich von ungefähr 50 bis 100 Nanometern aufweist, und
das Photoresist, das nach dem Entwickeln des belichteten Teils des Photoresists verbleibt, entfernt.

2. Verfahren nach Anspruch 1, wobei das Substrat Silicium umfasst.

3. Verfahren nach Anspruch 1, wobei das Photoresist ein Negativphotoresist umfasst.

4. Verfahren nach Anspruch 3, wobei das Negativphotoresist Polydimethylsiloxan oder SU-8 umfasst.

5. Verfahren nach Anspruch 1, wobei man beim Entwickeln des Photoresists das Photoresist unter Verwendung eines Lösungsmittels auflöst und einen Teil des Substrats freilegt.

6. Verfahren nach Anspruch 5, wobei das Lösungsmittel Propylenglykolmethyletheracetat, Ethyllactat oder Diacetonalkohol umfasst.

7. Verfahren nach Anspruch 1, bei dem man die Vorrichtung ferner in einem Gehäuse (211) unterbringt, wobei das Gehäuse Folgendes umfasst:
einen ein Fenster (201) umfassenden oberen Teil;
einen zur Aufnahme der Vorrichtung ausgelegten unteren Teil;
eine Einlassverbindung (203), die dazu ausgelegt ist, dass ein Fluid in die Vorrichtung eindringen kann; und
eine Auslassverbindung (205), die dazu ausgelegt ist, dass das Fluid aus der Vorrichtung austreten kann.

8. Verfahren nach Anspruch 7, wobei das Fenster ein elektrisch leitfähiges und optisch transparentes Material umfasst.

9. Verfahren nach Anspruch 8, wobei das leitfähige und transparente Material Siliciumnitrid umfasst.

10. System, umfassend:
eine Nanofluidikvorrichtung (200), wobei die Vorrichtung einen ein Substrat (209) umfassenden unteren Teil und einen eine Calcitkanalstruktur (207) umfassenden oberen Teil umfasst, wobei die Calcitkanalstruktur mindestens eine Seite mit einer Länge im Bereich von ungefähr 50 bis 100 Nanometern umfasst;
ein Gehäuse (211) für die Vorrichtung; und
eine Elektronenquelle zur Bereitstellung von einem Elektronenstrahl.

11. System nach Anspruch 10, wobei das Substrat Silicium umfasst.

12. System nach Anspruch 10, wobei es sich bei der Elektronenquelle um ein Rasterelektronenmikroskop handelt.

13. System nach Anspruch 10, wobei das Gehäuse Folgendes umfasst:
einen ein Fenster (201) umfassenden oberen Teil;
einen zur Aufnahme der Vorrichtung ausgelegten unteren Teil;
eine Einlassverbindung (203), die dazu ausgelegt ist, dass ein Fluid in die Vorrichtung eindringen kann; und
eine Auslassverbindung (205), die dazu ausgelegt ist, dass das Fluid aus der Vorrichtung austreten kann.

14. System nach Anspruch 13, wobei das Fenster ein elektrisch leitfähiges und optisch transparentes Material umfasst.

15. System nach Anspruch 14, wobei das leitfähige und transparente Material Siliciumnitrid umfasst.

## Revendications

1. Procédé de fabrication de canaux de calcite dans un dispositif nanofluidique (200), le procédé comprenant :
l'enduction d'un substrat (209) par une résine photosensible ;
l'exposition d'une partie de la résine photosensible à un faisceau d'électrons, la partie étant exposée selon un motif de canaux ;
le développement de la partie exposée de la résine photosensible dans le but de former le motif de canaux ;
le dépôt de calcite dans le motif de canaux à l'aide d'un gaz précurseur de calcite, la calcite déposée comportant au moins un côté présentant une longueur dans une plage d'environ 50 à 100 nanomètres ; et
l'élimination de la résine photosensible restante suite au développement de la partie exposée de la résine photosensible.

2. Procédé selon la revendication 1, dans lequel le substrat comprend du silicium.

3. Procédé selon la revendication 1, dans lequel la résine photosensible comprend une résine photosensible négative.

4. Procédé selon la revendication 3, dans lequel la résine photosensible négative comprend du polydiméthylsiloxane ou SU-8.

5. Procédé selon la revendication 1, dans lequel le développement de la résine photosensible comprend la dissolution de la résine photosensible à l'aide d'un solvant et la révélation d'une partie du substrat.

6. Procédé selon la revendication 5, dans lequel le solvant comprend l'acétate d'éther méthylique du propylèneglycol, le lactate d'éthyle ou le diacétone-alcool.

7. Procédé selon la revendication 1, comprenant en outre l'encapsulation du dispositif dans un boîtier (211), le boîtier comprenant :
une partie supérieure comprenant une fenêtre (201) ;
une partie inférieure configurée pour porter le dispositif ;
une connexion d'entrée (203) configurée pour laisser entrer un fluide dans le dispositif ; et
une connexion de sortie (205) configurée pour laisser sortir le fluide du dispositif.

8. Procédé selon la revendication 7, dans lequel la fenêtre comprend une matière électriquement conductrice et optiquement transparente.

9. Procédé selon la revendication 8, dans lequel la matière conductrice et transparente comprend du nitrure de silicium.

10. Système, comprenant :
un dispositif nanofluidique (200), le dispositif comprenant une partie inférieure comprenant un substrat (209) et une partie supérieure comprenant une structure de canaux de calcite (207), la structure de canaux de calcite comprenant au moins un côté présentant une longueur dans une plage d'environ 50 à 100 nanomètres ;
un boîtier (211) pour le dispositif ; et
une source d'électrons destinée à fournir un faisceau d'électrons.

11. Système selon la revendication 10, dans lequel le substrat comprend du silicium.

12. Système selon la revendication 10, dans lequel la source d'électrons est un microscope électronique à balayage.

13. Système selon la revendication 10, dans lequel le boîtier comprend :
une partie supérieure comprenant une fenêtre (201) ;
une partie inférieure configurée pour porter le dispositif ;
une connexion d'entrée (203) configurée pour laisser entrer un fluide dans le dispositif ; et
une connexion de sortie (205) configurée pour laisser sortir le fluide du dispositif.

14. Système selon la revendication 13, dans lequel la fenêtre comprend une matière électriquement conductrice et optiquement transparente.

15. Système selon la revendication 14, dans lequel la matière conductrice et transparente comprend du nitrure de silicium.
